# EUROPEAN PATENT APPLICATION

(11) **EP 4 467 393 A1**
(43) Date of publication of application: **27.11.2024**
(21) Application number: 24176189.9
(22) Date of filing: 16.05.2024
(51) Int. Cl.: B60R 1/26

(54) **REAR VIEW IMAGE DISPLAY SYSTEM**

(30) Priority: 22.05.2023 JP 2023093983
(71) Applicant: Alps Alpine Co., Ltd., Tokyo 145-8501 (JP)
(72) Inventor: Kudo, Nobunori, Iwaki-city Fukushima (JP)
(74) Representative: Schmitt-Nilson Schraud Waibel Wohlfrom Patentanwälte Partnerschaft mbB

(57) **Abstract**

Rear view image display system to display tractor's rear view image with less blind corners naturally is provided. Of parts of region of rear view image captured by tractor rear camera situated on tractor rear portion, the region being shielded by trailer, parts, view within which in directions from tractor rear camera to themselves is image-captured by trailer's side cameras without being shielded by trailer are replaced with images transformed from images captured by side cameras to tractor rear camera's viewing point. Of the remaining parts, a part, view within which in direction from tractor rear camera to itself is image-captured by trailer's rear camera without being shielded by trailer is replaced with image transformed from image captured by trailer's rear camera to tractor rear camera's viewing point, to generate rear view image to be displayed. Each part is calculated based on trailer's detected hitch angle.

## Description

The present disclosure relates to a technique of displaying a rear view image to a user of a tractor configured to pull a trailer.

A technique known as a technique for displaying a rear view image to a user of a tractor configured to pull a trailer displays an image captured by a camera situated on a rear portion of a trailer and an image of a rear view captured by a camera situated on a tractor, by synthesizing the images as if they represented one scene (for example, Japanese Patent Application Laid-Open Publication No. 2021-170826).

A technique also known as a technique for displaying a rear view image to a user of a tractor configured to pull a trailer generates a panorama view image representing a wide view around a trailer by synthesizing images captured by three cameras situated on left and right side portions and a rear portion of the trailer, cuts out a partial fixed-size range from the panorama view image, and displays the cut-out range while overlaying it on a region in which the trailer appears in an image of a rear view captured by a camera situated on a rear portion of a tractor (for example, Japanese Translation of PCT International Publication No. JP-T-2022-547068). Here, the technique changes the range to be displayed by being cut out from the panorama view image, in accordance with a hitch angle, which is a relative angle of the front-rear direction of the trailer with respect to the front-rear direction of the tractor.

Techniques known as techniques for detecting a hitch angle of a trailer include a technique of detecting a hitch angle by recognizing the center axis of a drawbar of a trailer from an image captured by a camera (for example, Japanese Patent Application Laid-Open Publication No. 2020-1631), a technique of calculating a hitch angle based on the distances from a tractor to both the left and right ends of a trailer in the front-rear direction of the tractor measured using a laser range finder (for example, Japanese Patent Application Laid-Open Publication No. 2021-177145), and a technique of detecting a hitch angle of a trailer based on the inclination of a pattern of a marker pasted on the upper surface of a drawbar of the trailer, an image of the marker being captured by a camera (for example, Japanese Patent Application Laid-Open Publication No. 2019-199150).

According to the technique of displaying an image captured by the camera situated on the rear portion of the trailer and an image of a rear view captured by the camera situated on the tractor by synthesizing the images, when the hitch angle of the trailer is large, there occurs behind the tractor, a region shielded against the camera situated on the tractor by a side surface of the trailer. As a result, there occurs a range, an image of which cannot be captured by any of the cameras and which hence cannot be displayed and is a blind corner to the user of the tractor.

According to the above-described technique of displaying a part of a panorama view image that is cut out in accordance with the hitch angle of the trailer, a range that is shielded against the camera situated on the tractor by a side surface of the trailer and corresponds to a part that is not to be cut out from the panorama view image occurs depending on the hitch angle, as a range behind the tractor, which is a blind corner to the user of the tractor.

Moreover, the image displayed by this technique is discontinuous and unnatural, because of, for example, an image captured by the camera situated on the tractor and an image cut out from the panorama view image being varied in the viewing point and the viewing direction, the size of a side surface of the trailer that appears in an image of a rear view captured by the camera situated on the rear portion of the tractor and hence the size of the trailer-appearing region in the displayed image being subject to changes in accordance with the hitch angle of the trailer whereas the size of a part of the panorama view image that is displayed while being overlaid on the trailer-appearing region being fixed, and the like.

Hence, an object of the present disclosure is to provide a rear view image display system which is capable to display an image representing a rear view of a tractor with a smaller blind corner range in a more natural manner.

The present disclosure relates to a rear view image display system according to the appended claims. Embodiments are disclosed in the dependent claims.

In an aspect, the present disclosure provides a rear view image display system configured to display a rear view image that is an image representing a rear view of a tractor configured to pull a trailer, with: a tractor rear camera that is a camera configured to capture an image of a rear view from a rear portion of the tractor; a trailer rear camera that is a camera configured to capture an image of a rear view from a rear portion of the trailer; a trailer right camera that is a camera configured to capture an image of a surrounding view of the trailer from a right side portion of the trailer; a trailer left camera that is a camera configured to capture an image of a surrounding view of the trailer from a left side portion of the trailer; a hitch angle detector configured to detect a hitch angle of the trailer; and a rear view image generating unit configured to generate the rear view image. The rear view image generating unit includes: a range calculator configured to calculate, based on the hitch angle detected by the hitch angle detector, a shielded direction range that is a direction range seen from the tractor rear camera, the rear view in the shielded direction range being shielded against the tractor rear camera by the trailer, a right replacement direction range in the shielded direction range, the right replacement direction range being a direction range seen from the tractor rear camera and fully unshielded against the trailer right camera by the trailer, a left replacement direction range in the shielded direction range, the left replacement direction range being a direction range seen from the tractor rear camera and fully unshielded against the trailer left camera by the trailer, and a rear replacement direction range other than the right replacement direction range and the left replacement direction range in the shielded direction range, the rear replacement direction range being a direction range unshielded against the trailer rear camera by the trailer; and a replacing unit configured to generate the rear view image by replacing a part of a tractor rear view image that is an image captured by the tractor rear camera, the part corresponding to the right replacement direction range, with an image appearing in a part, corresponding to the right replacement direction range, of an image obtained by transforming an image captured by the trailer right camera to an image seen from a same viewing point as that of the tractor rear view image, replacing a part of the tractor rear view image corresponding to the left replacement direction range with an image appearing in a part, corresponding to the left replacement direction range, of an image obtained by transforming an image captured by the trailer left camera to an image seen from the same viewing point as that of the tractor rear view image, and replacing a part of the tractor rear view image corresponding to the rear replacement direction range with an image appearing in a part, corresponding to the rear replacement direction range, of an image obtained by transforming an image captured by the trailer rear camera to an image seen from the same viewing point as that of the tractor rear view image.

Here, in the rear view image display system, the replacing unit may generate the rear view image by replacing a part of the tractor rear view image corresponding to a direction range that is other than the right replacement direction range, the left replacement direction range, and the rear replacement direction range in the shielded direction range with a predetermined pattern.

According to a further aspect, the present disclosure provides a rear view image display system configured to display a rear view image that is an image representing a rear view of a tractor configured to pull a trailer, with: a tractor rear camera that is a camera configured to capture an image of a rear view from a rear portion of the tractor; a trailer rear camera that is a camera configured to capture an image of a rear view from a rear portion of the trailer; a trailer right camera that is a camera configured to capture an image of a surrounding view of the trailer from a right side portion of the trailer; a trailer left camera that is a camera configured to capture an image of a surrounding view of the trailer from a left side portion of the trailer; a hitch angle detector configured to detect a hitch angle of the trailer; and a rear view image generating unit configured to generate the rear view image. The rear view image generating unit includes: a range calculator configured to calculate, based on the hitch angle detected by the hitch angle detector, a right replacement direction range that is a direction range seen from the tractor rear camera as being included in a right side surface of the trailer, a left replacement direction range that is a direction range seen from the tractor rear camera as being included in a left side surface of the trailer, and a rear replacement direction range that is a direction range seen from the tractor rear camera as being included in a rear surface of the trailer; and a replacing unit configured to generate the rear view image by replacing a part of a tractor rear view image that is an image captured by the tractor rear camera, the part corresponding to the right replacement direction range, with an image appearing in a part, corresponding to the right replacement direction range, of an image obtained by transforming an image captured by the trailer right camera to an image seen from a same viewing point as that of the tractor rear view image, replacing a part of the tractor rear view image corresponding to the left replacement direction range with an image appearing in a part, corresponding to the left replacement direction range, of an image obtained by transforming an image captured by the trailer left camera to an image seen from the same viewing point as that of the tractor rear view image, and replacing a part of the tractor rear view image corresponding to the rear replacement direction range with an image appearing in a part, corresponding to the rear replacement direction range, of an image obtained by transforming an image captured by the trailer rear camera to an image seen from the same viewing point as that of the tractor rear view image.

Here, in the rear view image display system, the range calculator may calculate a masking direction range that is a direction range seen from the tractor rear camera as being included in a bottom surface of the trailer, based on the hitch angle detected by the hitch angle detector, and the replacing unit may generate the rear view image by replacing a part of the tractor rear view image corresponding to the masking direction range with a predetermined pattern.

As described above, according to aspects of the present disclosure the rear view image display system generates a rear view image representing the rear view of the tractor by replacing parts of an image captured by the camera situated on the rear portion of the tractor, the parts being shielded by the trailer, with images obtained by viewing-point-wise transforming images, which are captured for the same direction ranges as those of the shielded parts by the three cameras situated on the rear portion of the trailer, the right side portion of the trailer, and the left side portion of the trailer, to images seen from the viewing point of the camera situated on the rear portion of the tractor.

Here, the three cameras situated on the rear portion of the trailer, the right side portion of the trailer, and the left side portion of the trailer can capture images of views that are behind, on the right-hand side of, and on the left-hand side of the trailer without omission.

The parts of the image captured by the camera situated on the rear portion of the tractor, the parts being shielded by the trailer, are replaced with images seen from the same viewing point as that of the image.

Hence, the rear view image display system can generate and display, as the rear view image, an image that represents, without any blind corner, seamlessly, and without any unnaturalness, a view in a wide range behind the tractor, which could generally be seen from the viewing point of the camera situated on the rear portion of the tractor if the trailer were transparent.

As described above, the present disclosure can display an image representing a rear view of a tractor with a smaller blind corner range in a more natural manner.
FIG. 1 is a block diagram illustrating the configuration of a drive assisting system according to an embodiment of the present disclosure;
FIG. 2A is a view illustrating a tractor and a trailer according to an embodiment of the present disclosure;
FIG. 2B is a view illustrating a tractor and a trailer according to an embodiment of the present disclosure;
FIG. 3A is a view illustrating a hitch angle to be detected according to an embodiment of the present disclosure;
FIG. 3B is a view illustrating a hitch angle to be detected according to an embodiment of the present disclosure;
FIG. 4 is a view illustrating ranges in which images are used according to an embodiment of the present disclosure;
FIG. 5A is a view illustrating ranges in which images are used according to an embodiment of the present disclosure;
FIG. 5B is a view illustrating ranges in which images are used according to an embodiment of the present disclosure;
FIG. 6A is a view illustrating regions to which images are synthesized according to an embodiment of the present disclosure;
FIG. 6B is a view illustrating regions to which images are synthesized according to an embodiment of the present disclosure;
FIG. 7A is a view illustrating regions to which images are synthesized according to an embodiment of the present disclosure;
FIG. 7B is a view illustrating regions to which images are synthesized according to an embodiment of the present disclosure;
FIG. 8A is a view illustrating regions to which images are synthesized according to an embodiment of the present disclosure;
FIG. 8B is a view illustrating regions to which images are synthesized according to an embodiment of the present disclosure;
FIG. 9 is a view illustrating an example of a rear view image according to an embodiment of the present disclosure;
FIG. 10 is a view illustrating an example of a rear view image according to an embodiment of the present disclosure;
FIG. 11A is a view illustrating an example of a rear view image according to an embodiment of the present disclosure;
FIG. 11B is a view illustrating an example of a rear view image according to an embodiment of the present disclosure;
FIG. 11C is a view illustrating an example of a rear view image according to an embodiment of the present disclosure; and
FIG. 12 is a view illustrating an example of a rear view image according to an embodiment of the present disclosure.

Embodiments of the present disclosure will be described below.

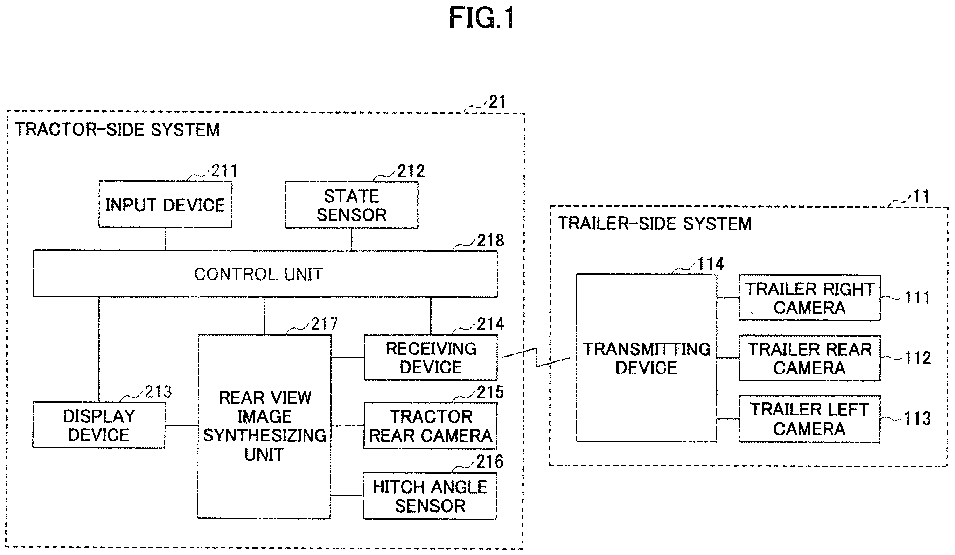

FIG. 1 illustrates a configuration of a drive assisting system according to an embodiment.

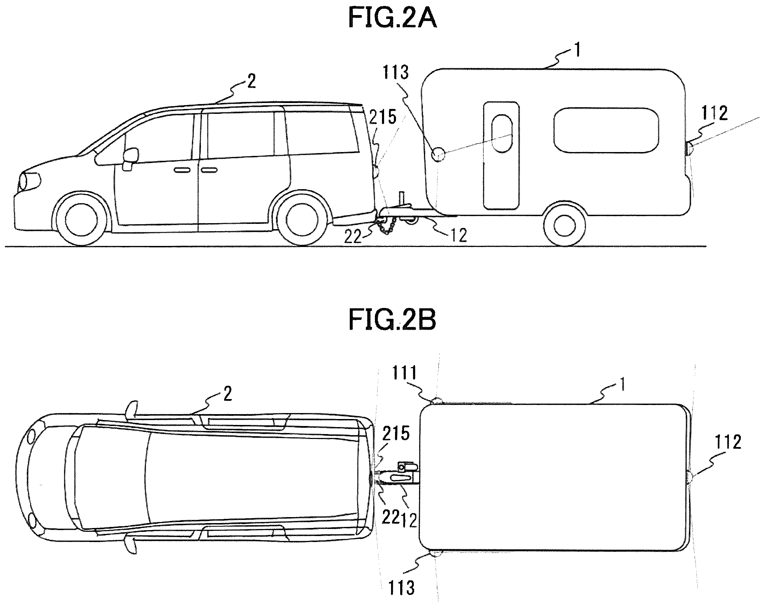

The drive assisting system is configured to assist in driving of a tractor vehicle (or generally tractor) 2 configured to pull a trailer 1 such as a camping trailer and the like illustrated in FIG. 2A and FIG. 2B.

Referring back to FIG. 1, the drive assisting system includes a trailer-side system 11 mounted on the trailer 1, and a tractor-side system 21 mounted on the tractor 2.

The trailer-side system 11 includes three cameras including a trailer right camera 111, a trailer rear camera 112, and a trailer left camera 113, and a transmitting device 114 configured to wirelessly transmit images captured by the cameras to the tractor-side system 21.

The tractor-side system 21 includes an input device 211, a state sensor 212 configured to detect various states of the tractor 2 such as the forward/reverse travelling state of the tractor 2, the steered angle of the tractor 2, and the like, a display device 213, a receiving device 214 configured to receive images wirelessly transmitted from the transmitting device 114 of the trailer-side system 11, a tractor rear camera 215, a hitch angle sensor 216 configured to detect a hitch angle of the trailer 1, a rear view image synthesizing unit 217 configured to generate a rear view image by synthesizing images captured by the trailer right camera 111, the trailer rear camera 112, and the trailer left camera 113, received by the receiving device 214, and an image captured by the tractor rear camera 215, and to display the rear view image on the display device 213, and a control unit 218 configured to control each of the units described above.

The images captured by the trailer right camera 111, the trailer rear camera 112, and the trailer left camera 113 may be transmitted from the trailer-side system 11 to the tractor-side system 21 by wired transmission. In this case, the transmitting device 114 and the receiving device 214 are omitted, and the images captured by the trailer right camera 111, the trailer rear camera 112, and the trailer left camera 113 are directly transmitted to the rear view image synthesizing unit 217.

As illustrated in FIG. 2A and FIG. 2B, the trailer right camera 111 of the trailer-side system 11 captures an image of the rear view from a position near the front end of the right side of the trailer 1, the trailer rear camera 112 captures an image of the rear view from the left-right direction center position of the rear portion of the trailer 1, and the trailer left camera 113 captures an image of the rear view from a position near the front end of the left side of the trailer 1.

The tractor rear camera 215 of the tractor-side system 21 captures an image of the rear view from the left-right direction center position of the rear portion of the tractor 2.

A drawbar 12 coupling with the chassis extends from a lower portion of the front end of the trailer 1 to ahead of the trailer 1. By a coupler situated on the front end of the drawbar 12 being swingably engaged with a hitch ball situated on the rear end of a hitch member 22 extending to behind the tractor 2 from a lower portion of the rear end of the tractor 2, the trailer 1 is coupled to the tractor 2.

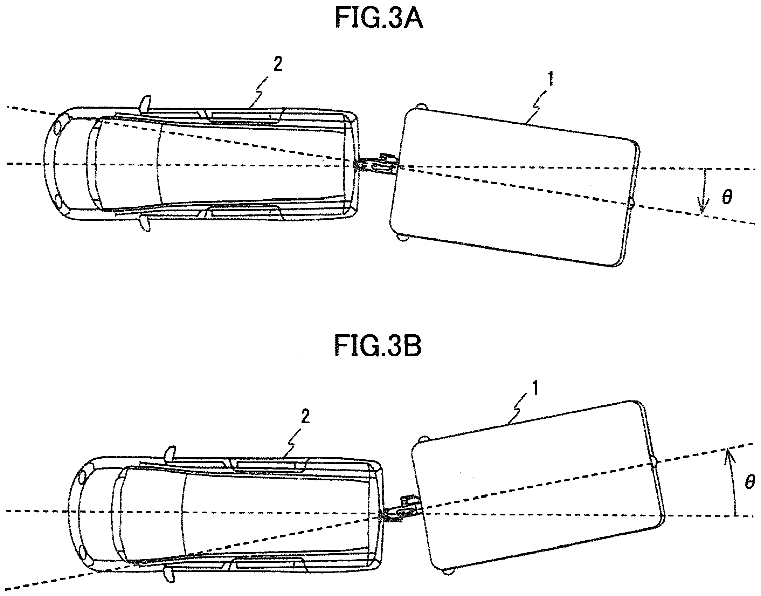

Hence, as illustrated in FIG. 3A and FIG. 3B, the trailer 1 can swing with respect to the tractor 2 about the upper-lower direction center axis of the coupler and the hitch ball. The angle θ of the swinging is the hitch angle of the trailer 1 to be detected by the hitch angle sensor 216.

Generation of a rear view image performed by the rear view image synthesizing unit 217 will be described below.

Here, generation and display of the rear view image may be performed constantly, or may be performed only in a period of time in which the state sensor 212 is detecting that the tractor 2 is reversing, or may be performed in response to a user's operation.

In the following description, an image output by the trailer right camera 111 is referred to as a trailer right view image, an image output by the trailer left camera 113 is referred to as a trailer left view image, an image output by the trailer rear camera 112 is referred to as a trailer rear view image, and an image output by the tractor rear camera 215 is referred to as a tractor rear view image. These cameras are configured to output images flipped left to right (mirror images).

First, a positional relationship between each of the trailer right camera 111, the trailer left camera 113, and the trailer rear camera 112, and the tractor rear camera 215 is calculated based on the hitch angle θ of the trailer 1 detected by the hitch angle sensor 216, and, in accordance with the calculated positional relationship, a viewing point transform function for viewing-point-wise transforming a trailer right view image to an image captured from the position of the tractor rear camera 215, a viewing point transform function for viewing-point-wise transforming a trailer left view image to an image captured from the position of the tractor rear camera 215, and a viewing point transform function for viewing-point-wise transforming a trailer rear view image to an image captured from the position of the tractor rear camera 215 are set.

Here, per hitch angle, a viewing point transform function for each image may be previously calculated and registered in association with the hitch angle, and the viewing point transform function registered in association with a hitch angle θ detected by the hitch angle sensor 216 may be used as the viewing point transform function to be set in generating a rear view image.

Based on the hitch angle θ of the trailer 1 detected by the hitch angle sensor 216, the rear view image synthesizing unit 217 sets extraction regions, which are regions defining image parts to be extracted from the trailer right view image, the trailer left view image, and the trailer rear view image, to be synthesized with a tractor rear view image.

The extraction regions are set as follows.

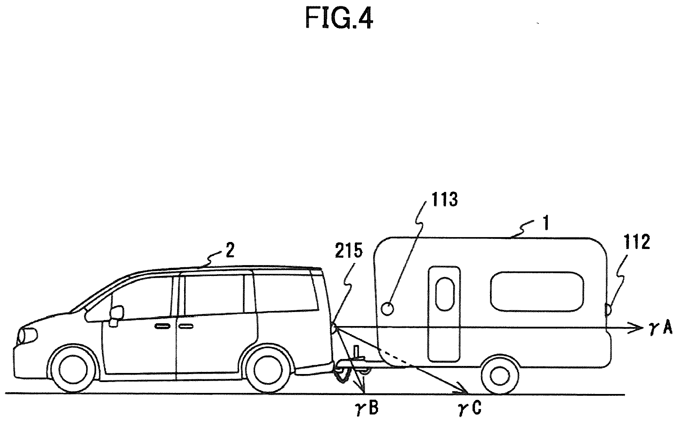

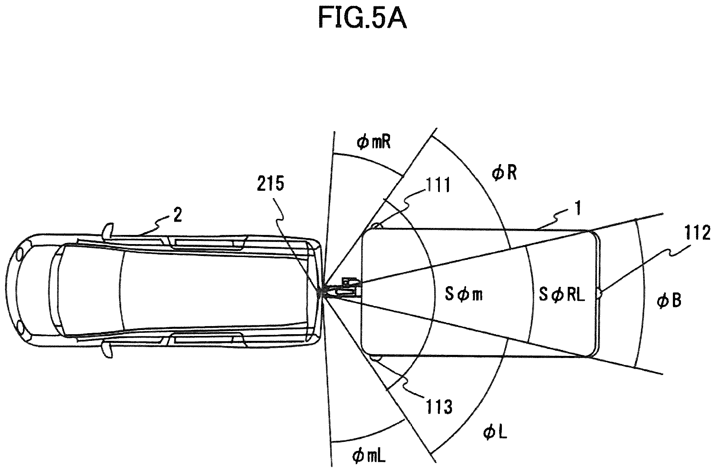

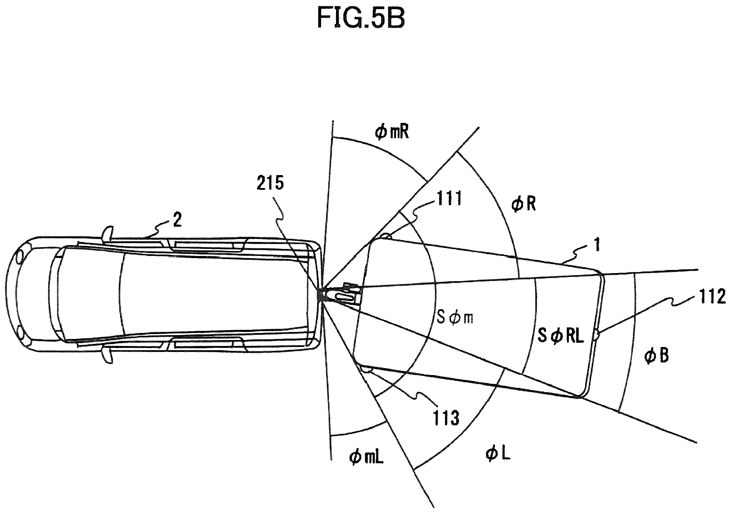

That is, regarding a left-right direction angular range that is at an angle of elevation or depression (i.e., an upper-lower direction angle) γA when seen from the tractor rear camera 215 illustrated in FIG. 4, an angular range Sϕm illustrated in FIG. 5A and FIG. 5B, which is within a horizontal-direction image-capturing angular field of view ϕmR + Sϕm + ϕmL of the tractor rear camera 215, is calculated. The angular range Sϕm is a range that is defined in accordance with the hitch angle θ and is shielded against the tractor rear camera 215 by the trailer 1.

Then, a region of the trailer right view image that corresponds to an angular range cpR within the angular range Scpm is determined in accordance with the hitch angle θ. The angular range cpR is a range, a rear view behind the tractor 2 within which range in the direction defined by the angle of elevation or depression γA appears as an image fully without being shielded by the trailer 1, in a version of the trailer right view image that is viewing-point-wise transformed to an image captured from the position of the tractor rear camera 215 in a case of viewing-point-wise transforming the trailer right view image using the set viewing point transform function.

Regarding the other angles of elevation or depression within the angular field of view of the tractor rear camera 215, a region of the trailer right view image that corresponds to the angular range ϕR is likewise determined in accordance with the hitch angle θ, and a region obtained by combining the regions determined for every angle of elevation or depression is set as the extraction region defining the image part to be extracted from the trailer right view image.

A region of the trailer left view image that corresponds to an angular range ϕL within the angular range Sϕm is determined in accordance with the hitch angle θ. The angular range ϕL is a range, a rear view behind the tractor 2 within which range in the direction defined by the angle of elevation or depression γA appears as an image fully without being shielded by the trailer 1 in a version of the trailer left view image that is viewing-point-wise transformed to an image captured from the position of the tractor rear camera 215 in a case of viewing-point-wise transforming the trailer left view image using the set viewing point transform function.

Regarding the other angles of elevation or depression within the angular field of view of the tractor rear camera 215, a region of the trailer left view image that corresponds to the angular range cpL is likewise determined in accordance with the hitch angle θ, and a region obtained by combining the regions determined for every angle of elevation or depression is set as the extraction region defining the image part to be extracted from the trailer left view image.

A region of the trailer rear view image that corresponds to an angular range ϕB within an angular range SϕRL between the angular range ϕR and the angular range cpL is determined in accordance with the hitch angle θ. The angular range ϕB is a range, a rear view behind the tractor 2 within which range in the direction defined by the angle of elevation or depression γA appears as an image in a version of the trailer rear view image that is viewing-point-wise transformed to an image captured from the position of the tractor rear camera 215 in a case of viewing-point-wise transforming the trailer rear view image using the set viewing point transform function.

Regarding the other angles of elevation or depression within the angular field of view of the tractor rear camera 215, a region of the trailer rear view image that corresponds to the angular range ϕB is likewise determined in accordance with the hitch angle θ, and a region obtained by combining the regions determined for every angle of elevation or depression is set as the extraction region defining the image part to be extracted from the trailer rear view image.

Here, the angular range ϕR, the angular range ϕL, and the angular range ϕB, for which images are extracted, are determined in accordance with the hitch angle θ, and change in accordance with the hitch angle θ as illustrated in FIG. 5A and FIG. 5B.

Moreover, the angular range cpR, the angular range ϕL, and the angular range ϕB, for which images are extracted, are different per range of the angle of elevation or depression seen from the tractor rear camera 215. For example, in a left-right direction range at an angle of elevation or depression γB illustrated in FIG. 4, at which the tractor rear camera 215 captures an image of the space between the tractor 2 and the trailer 1, there exists no angular range Sϕm, in which there is shielding against the tractor rear camera 215 by the trailer 1 (without taking shielding by the drawbar 12 into consideration). Moreover, no angular range ϕR, angular range ϕL, and angular range ϕB are set in a left-right direction range at an angle of elevation or depression γC, which defines a direction extending to exactly under the trailer 1 as seen from the tractor rear camera 215, because the trailer right camera 111, the trailer left camera 113, and the trailer rear camera 112 do not capture images in this left-right direction range.

To set the extraction regions, each image's extraction region corresponding to each hitch angle may be previously calculated and registered per hitch angle. In generating a rear view image, an extraction region registered in association with a hitch angle θ detected by the hitch angle sensor 216 may be used as the extraction region to be set.

Next, the image parts in the extraction regions of the trailer right view image, the trailer left view image, and the trailer rear view image, which are set in accordance with the hitch angle θ, are extracted from the extraction regions, and the extracted image parts are viewing-point-wise transformed to images captured from the position of the tractor rear camera 215 using the set viewing point transform functions.

Extraction and viewing point transformation of the image parts may be exchanged in order. The respective image parts may be extracted after the trailer right view image, the trailer left view image, and the trailer rear view image are viewing-point-wise transformed to images captured from the position of the tractor rear camera 215.

Then, a region of the tractor rear view image that corresponds to a trailer right view image part, which is the image obtained by viewing-point-wise transforming the image part extracted from the trailer right view image, is replaced with the trailer right view image part, a region of the tractor rear view image that corresponds to a trailer left view image part, which is the image obtained by viewing-point-wise transforming the image part extracted from the trailer left view image, is replaced with the trailer left view image part, and a region of the tractor rear view image that corresponds to a trailer rear view image part, which is the image obtained by viewing-point-wise transforming the image part extracted from the trailer rear view image, is replaced with the trailer rear view image part, to thereby generate a rear view image.

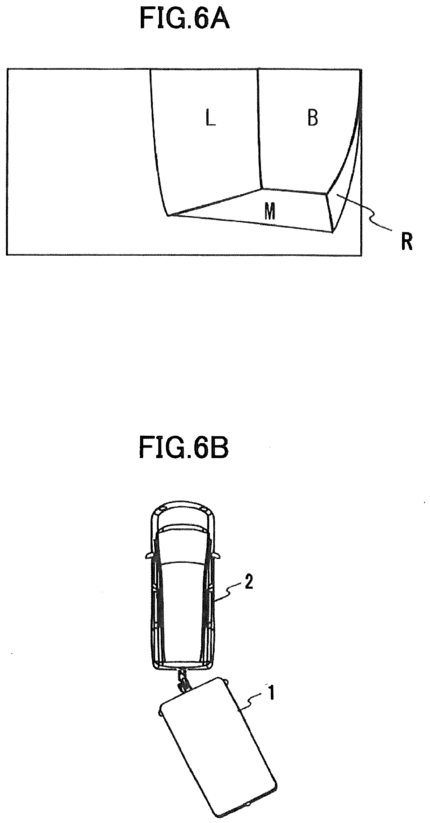

FIG. 6A, FIG. 7A, and FIG. 8A illustrate the regions of the tractor rear view image replaced with the trailer right view image part, the trailer left view image part, and the trailer rear view image part in the way described above. R denotes the region replaced with the trailer right view image part, L denotes the region replaced with the trailer left view image part, and B denotes the region replaced with the trailer rear view image part. M denotes a blind corner region, for which no image of a rear view behind the tractor 2 is captured by any of the cameras.

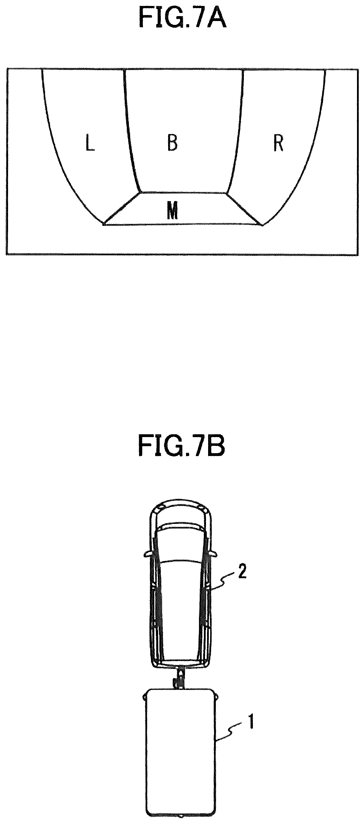

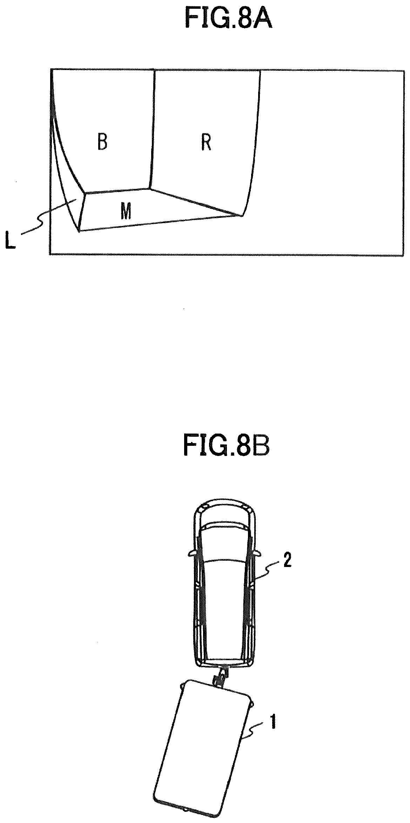

FIG. 6A illustrates the regions of the tractor rear view image replaced in a case where the hitch angle θ is as illustrated in FIG. 6B. FIG. 7A illustrates the regions of the tractor rear view image replaced in a case where the hitch angle θ is as illustrated in FIG. 7B. FIG. 8A illustrates the regions of the tractor rear view image replaced in a case where the hitch angle θ is as illustrated in FIG. 8B. As illustrated, these regions change in accordance with the hitch angle θ.

As illustrated in FIG. 4 to FIG. 8B, in a case where the shape of the trailer 1 is roughly a box shape (a rectangular parallelepiped shape), the trailer right view image part and the region R of the tractor rear view image replaced with the trailer right view image part are a part representing a range that is seen from the tractor rear camera 215 as existing approximately in a direction that is included in the right side surface of the trailer 1, the trailer left view image part and the region L of the tractor rear view image replaced with the trailer left view image part are a part representing a range that is seen from the tractor rear camera 215 as existing approximately in a direction that is included in the left side surface of the trailer 1, the trailer rear view image part and the region B of the tractor rear view image replaced with the trailer rear view image part are a part representing a range that is seen from the tractor rear camera 215 as existing approximately in a direction that is included in the rear surface of the trailer 1, and the blind corner region M is a part representing a range that is seen from the tractor rear camera 215 as existing approximately in a direction that is included in the bottom surface of the trailer 1.

Hence, by the region R, the region L, and the region B of the tractor rear view image being replaced with the trailer right view image part, the trailer left view image part, and the trailer rear view image part, respectively, an image of the rear view behind the tractor 2 that is roughly seen from the position of the tractor rear camera 215 through the respective portions of the trailer 1 except any portion that exists in a direction included in the bottom surface of the trailer 1 is generated as a rear view image.

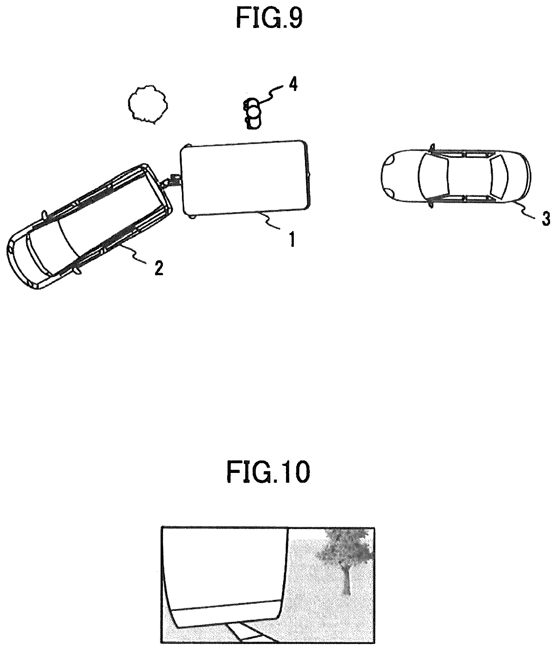

FIG. 9 to FIG. 12 illustrate an example of a rear view image generated in the way described above.

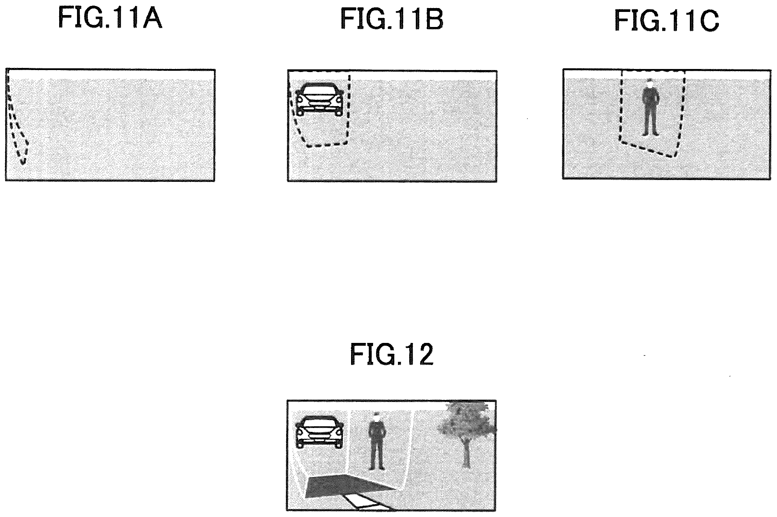

Here, it is assumed that in a situation in which another vehicle 3 exists behind the trailer 1, a person 4 exists on the right-hand side of the trailer 1, and the another vehicle 3 and the person 4 are shielded against the tractor rear camera 215 by the trailer 1 as illustrated in FIG. 9, a tractor rear view image is captured by the tractor rear camera 215 as illustrated in FIG. 10, a trailer left view image is captured by the trailer left camera 113 and viewing-point-wise transformed to an image illustrated in FIG. 11A, a trailer rear view image is captured by the trailer rear camera 112 and viewing-point-wise transformed to an image illustrated in FIG. 11B including the image of the another vehicle 3, and a trailer right view image is captured by the trailer right camera 111 and viewing-point-wise transformed to an image illustrated in FIG. 11C including the image of the person 4.

In this case, a rear view image is generated and displayed as illustrated in FIG. 12.

As illustrated, the rear view image is an image obtained by replacing the images of the regions of the tractor rear view image, the regions being shielded against the tractor rear camera 215 by the respective portions of the trailer 1 except the portion that exists in the direction included in the bottom surface of the trailer 1, with images appearing in the regions denoted by broken lines in the viewing-point-wise transformed version of the trailer left view image illustrated in FIG. 11A, the viewing-point-wise transformed version of the trailer rear view image illustrated in FIG. 11B, and the viewing-point-wise transformed version of the trailer right view image illustrated in FIG. 11C. The rear view image includes the images of the another vehicle 3 and the person 4 that cannot be captured by the tractor rear camera 215.

Hence, the rear view image represents with a less blind corner and seamlessly, a rear view in a wide range behind the tractor 2, while including the images of the another vehicle 3 and the person 4, which would generally be seen from the viewing point of the tractor rear camera 215 if the trailer 1 were transparent.

In this example, the blind corner region M, which is as illustrated in FIG. 6A, FIG. 7A, and FIG. 8A, for which no image of a rear view behind the tractor 2 is captured by any of the cameras, is solidly painted in a single color when the rear view image is generated, because the tractor rear view image, if displayed as is, would be discontinuous from the surrounding and unnatural. This solid painting may be performed using another pattern.

An embodiment of the present disclosure has been described above.

Here, in a case where the shape of the trailer 1 is roughly a box shape (a rectangular parallelepiped shape) as described above, the trailer right view image part and the region R of the tractor rear view image replaced with the trailer right view image part are a part representing a range that is seen from the tractor rear camera 215 as existing approximately in a direction that is included in the right side surface of the trailer 1, the trailer left view image part and the region L of the tractor rear view image replaced with the trailer left view image part are a part representing a range that is seen from the tractor rear camera 215 as existing approximately in a direction that is included in the left side surface of the trailer 1, and the trailer rear view image part and the region B of the tractor rear view image replaced with the trailer rear view image part are a part representing a range that is seen from the tractor rear camera 215 as existing approximately in a direction that is included in the rear surface of the trailer 1. Hence, in the embodiment described above in a case of being applied to a trailer 1 having roughly a box shape (a rectangular parallelepiped shape), a trailer right view image part, a trailer left view image part, and a trailer rear view image part may be generated as follows based on the hitch angle θ.

That is, a trailer right view image part may be a part obtained by extracting from a trailer right view image, a region of the trailer right view image that is supposed to represent a range of directions that are included in the right side surface of the trailer 1 through viewing point transformation, and then by viewing-point-wise transforming the extracted region, or may be a region representing a range of directions that are included in the right side surface of the trailer 1, the region being extracted from a viewing-point-wise transformed version of a trailer right view image. Likewise, a trailer left view image part may be a part obtained by extracting from a trailer left view image, a region of the trailer left view image that is supposed to represent a range of directions that are included in the left side surface of the trailer 1 through viewing point transformation, and then by viewing-point-wise transforming the extracted region, or may be a region representing a range of directions that are included in the left side surface of the trailer 1, the region being extracted from a viewing-point-wise transformed version of a trailer left view image. A trailer rear view image part may be a part obtained by extracting from a trailer rear view image, a region of the trailer rear view image that is supposed to represent a range of directions that are included in the rear surface of the trailer 1 through viewing point transformation, and then by viewing-point-wise transforming the extracted region, or may be a region representing a range of directions that are included in the rear surface of the trailer 1, the region being extracted from a viewing-point-wise transformed version of a trailer rear view image.

## Claims

1. A rear view image display system configured to display a rear view image that is an image representing a rear view of a tractor configured to pull a trailer, the rear view image display system comprising:
a tractor rear camera that is a camera configured to capture an image of a rear view from a rear portion of the tractor;
a trailer rear camera that is a camera configured to capture an image of a rear view from a rear portion of the trailer;
a trailer right camera that is a camera configured to capture an image of a surrounding view of the trailer from a right side portion of the trailer;
a trailer left camera that is a camera configured to capture an image of a surrounding view of the trailer from a left side portion of the trailer;
a hitch angle detector configured to detect a hitch angle of the trailer; and
a rear view image generating unit configured to generate the rear view image,
wherein the rear view image generating unit includes:
a range calculator configured to calculate, based on the hitch angle detected by the hitch angle detector,
a shielded direction range that is a direction range seen from the tractor rear camera, the rear view in the shielded direction range being shielded against the tractor rear camera by the trailer,
a right replacement direction range in the shielded direction range, the right replacement direction range being a direction range seen from the tractor rear camera and fully unshielded against the trailer right camera by the trailer,
a left replacement direction range in the shielded direction range, left replacement direction range being a direction range seen from the tractor rear camera and fully unshielded against the trailer left camera by the trailer, and
a rear replacement direction range other than the right replacement direction range and the left replacement direction range in the shielded direction range, the rear replacement direction range being a direction range unshielded against the trailer rear camera by the trailer; and
a replacing unit configured to generate the rear view image by
replacing a part of a tractor rear view image that is an image captured by the tractor rear camera, the part corresponding to the right replacement direction range, with an image appearing in a part, corresponding to the right replacement direction range, of an image obtained by transforming an image captured by the trailer right camera to an image seen from a same viewing point as that of the tractor rear view image,
replacing a part of the tractor rear view image corresponding to the left replacement direction range with an image appearing in a part, corresponding to the left replacement direction range, of an image obtained by transforming an image captured by the trailer left camera to an image seen from the same viewing point as that of the tractor rear view image, and
replacing a part of the tractor rear view image corresponding to the rear replacement direction range with an image appearing in a part, corresponding to the rear replacement direction range, of an image obtained by transforming an image captured by the trailer rear camera to an image seen from the same viewing point as that of the tractor rear view image.

2. A rear view image display system configured to display a rear view image that is an image representing a rear view of a tractor configured to pull a trailer, the rear view image display system comprising:
a tractor rear camera that is a camera configured to capture an image of a rear view from a rear portion of the tractor;
a trailer rear camera that is a camera configured to capture an image of a rear view from a rear portion of the trailer;
a trailer right camera that is a camera configured to capture an image of a surrounding view of the trailer from a right side portion of the trailer;
a trailer left camera that is a camera configured to capture an image of a surrounding view of the trailer from a left side portion of the trailer;
a hitch angle detector configured to detect a hitch angle of the trailer; and
a rear view image generating unit configured to generate the rear view image,
wherein the rear view image generating unit includes:
a range calculator configured to calculate, based on the hitch angle detected by the hitch angle detector,
a right replacement direction range that is a direction range seen from the tractor rear camera as being included in a right side surface of the trailer,
a left replacement direction range that is a direction range seen from the tractor rear camera as being included in a left side surface of the trailer, and
a rear replacement direction range that is a direction range seen from the tractor rear camera as being included in a rear surface of the trailer; and
a replacing unit configured to generate the rear view image by
replacing a part of a tractor rear view image that is an image captured by the tractor rear camera, the part corresponding to the right replacement direction range, with an image appearing in a part, corresponding to the right replacement direction range, of an image obtained by transforming an image captured by the trailer right camera to an image seen from a same viewing point as that of the tractor rear view image,
replacing a part of the tractor rear view image corresponding to the left replacement direction range with an image appearing in a part, corresponding to the left replacement direction range, of an image obtained by transforming an image captured by the trailer left camera to an image seen from the same viewing point as that of the tractor rear view image, and
replacing a part of the tractor rear view image corresponding to the rear replacement direction range with an image appearing in a part, corresponding to the rear replacement direction range, of an image obtained by transforming an image captured by the trailer rear camera to an image seen from the same viewing point as that of the tractor rear view image.

3. The rear view image display system according to claim 1,
wherein the replacing unit is configured to generate the rear view image by replacing a part of the tractor rear view image corresponding to a direction range that is other than the right replacement direction range, the left replacement direction range, and the rear replacement direction range in the shielded direction range with a predetermined pattern.

4. The rear view image display system according to claim 2,
wherein the range calculator calculates a masking direction range that is a direction range seen from the tractor rear camera as being included in a bottom surface of the trailer, based on the hitch angle detected by the hitch angle detector, and
the replacing unit generates the rear view image by replacing a part of the tractor rear view image corresponding to the masking direction range with a predetermined pattern.
